Europäisches Patentamt

European Patent Office

Office européen des brevets

(11) Veröffentlichungsnummer : **0 115 025**
**B1**

## EUROPÄISCHE PATENTSCHRIFT

(45) Veröffentlichungstag der Patentschrift :
25.05.88

(51) Int. Cl.⁴ : **G 01 D   5/26**

(21) Anmeldenummer : 83112820.2

(22) Anmeldetag : 20.12.83

(54) Optischer Sensor.

(30) Priorität : 23.12.82 DE 3247659

(43) Veröffentlichungstag der Anmeldung :
08.08.84 Patentblatt 84/32

(45) Bekanntmachung des Hinweises auf · die Patenterteilung : 25.05.88 Patentblatt 88/21

(84) Benannte Vertragsstaaten :
AT CH DE FR GB LI NL SE

(56) Entgegenhaltungen :
EP-A- 0 029 653
EP-A- 0 049 048
EP-A- 0 091 394
EP-A- 0 095 673
WO-A-79 /003 77
DE-A- 1 623 802
DE-A- 1 803 671
DE-A- 3 012 328
DE-A- 3 047 343
DE-A- 3 119 570
DE-B- 1 755 074
FR-A- 2 034 979
FR-A- 2 103 683
GB-A- 2 042 168
GB-A- 2 097 528
US-A- 2·569 127
US-A- 3 745 359
US-A- 3 934 148
US-A- 4 151 747
US-A- 4 288 159
US-A- 4 403 826
DER ELEKTRONIKER, Band 15, nr. 10, Oktober 1976,
S. 25-28, Aarau, CH, J. OBERHÄNSLI: "Elektrooptische Flüssigkeitssonden"

(73) Patentinhaber : Ruhrmann, Wolfgang Dr.
Herrenberger Str. 24
D-7000 Stuttgart 80 (DE)

(72) Erfinder : Ruhrmann, Wolfgang Dr.
Herrenberger Str. 24
D-7000 Stuttgart 80 (DE)

(74) Vertreter : Patentanwälte Dr. Ing. Eugen Maier Dr. Ing.
Eckhard Wolf
Pischekstrasse 19
D-7000 Stuttgart 1 (DE)

PATENTS ABSTRACTS OF JAPAN, Band 7, nr. 78, 31. März 1983, S. 1223 P188 & JP-A- 58 7604 (MITSUBISHI DENKI K.K.) ( 17-01-1983)
PATENTS ABSTRACTS OF JAPAN, Band 7, nr. 168, 23. Juli 1983, S. 1313 P-212 & JP-A- 58 75046 (NIPPON DENKI K.K.) (06-05-1983)
PATENTS ABSTRACTS OF JAPAN, Band 6, nr. 203, 14. Oktober 1982, S. 1081 P-148 & JP-A- 57 110941 (MISUBISHI DENKI K.K.) (10-07-1982)
JOURNAL OF NUCLEAR MEDECINE, Band 6, 1966, New York, US, T. DAVIS et al.: "The hybrid radio-isotope scanner", S. 114-127
NUCLEAR INSTRUMENTS AND METHODS, Band 163, Nr. 2/3, Juli 1979, Amsterdam, NL, K. MILLER: "A gaz scintillation proportional counter using a photo-multiplier tube array", S. 583-586

2

## Beschreibung

Die Erfindung betrifft einen optischen Sensor für Meß-, Steuer- und Regelanordnungen sowie Verwendungsmöglichkeiten eines solchen Sensors.

Die Meß- und Regeltechnik hat in den letzten Jahren durch den Einsatz der Digital-Technik große Fortschritte gemacht. Im Zusammenhang damit wird eine steigende Zahl genauer und vielfältiger Sensoren für physikalische Größen aller Art benötigt. Diese Entwicklung fällt zusammen mit der Einführung der Lichtleitfaser mit den zugehörigen optoelektronischen Sende- und Empfangselementen als neuem Übertragungsmedium. Deren Vorteile sind bekannt : hohe Bandbreite, elektrische Potentialtrennung, weitgehende Unempfindlichkeit gegen elektrische und magnetische Störfelder und extreme Temperaturen, Benutzbarkeit in explosiver oder korrosiver Umgebung, geringer Platzbedarf, kleines Gewicht. Mit den üblichen elektronischen Sensoren können diese Vorteile nur genutzt werden, wenn dem Sensor ein Wandler nachgeschaltet ist, der das elektrische Ausgangssignal in ein optisches Signal umsetzt, das dann über die Faser nur Anzeigeeinheit oder zum Regler transportiert werden kann. Es findet hier also eine zweimalige Umsetzung statt. Aus Gründen der Meßgenauigkeit, Linearität und Stabilität besteht daher ein Bedarf an Sensoren, die die zu messende Größe unmittelbar in ein geeignetes Lichtsignal umsetzen.

Aus der EP-A-0 029 653 ist ein optischer Sensor bekannt, der eine Sonde aufweist, die über eine Lichtquelle anregbare Lumineszenzteilchen sowie eine Meßstelle zum Auskoppeln des dorthin gelangenden Lumineszenzlichts enthält. Die Lumineszenzsonde ist dort in einer Heizzelle enthalten, deren Temperatur gemessen werden soll. Die Messung macht dabei einmal davon Gebrauch, daß das Lumineszenzlicht eine andere Wellenlänge als das Primärlicht aufweist. Zum anderen beruht das Meßprinzip auf einer Bestimmung von Änderungen in der Lebensdauer des emittierten Lumineszenzlichts, die bei gepulstem Primärlicht aus der Phasenverschiebung des Lumineszenzlichts ermittelt werden. Die gleichförmige Richtungsverteilung des Lumineszenzlichts und etwaige Brechungsindexunterschiede spielen bei dieser Meßmethode keine Rolle.

Weiter ist es bei einer Einrichtung zur Messung physikalischer Größen durch Messung der Intensität eines Lichtstrahlenbündels an sich bekannt (FR-A-2 103 683), einen langestreckten Sondenkörper zu verwenden, der aus einem lichtdurchlässigen, einen bestimmten Brechungsindex aufweisenden Medium besteht und der in ein Meßmedium mit abweichendem Brechungsindex eintauchbar ist. Es wird dort ausschließlich der durchgehende Anteil des Primärlichts oder dessen am Ende reflektierter Anteil erfasst. Der Lichttransport innerhalb des Lichtleiters erfolgt unter einem Winkel, der dem Totalreflexionswinkel des Sondenkörpers gegenüber der Luft oberhalb des Flüssigkeitsspiegels entspricht. Eine kontinuierliche Pegelmessung mit diesem Verfahren ist nur dann möglich, wenn der Brechungsindex der Flüssigkeit gleich oder geringfügig kleiner als der des Sondenkörpers ist. Ist der Brechungsindex in der Flüssigkeit auch nur geringfügig größer als in der Sonde, so tritt bei den vielfachen Wandreflexionen die gesamte Primärstrahlung in die Flüssigkeit aus, so daß kein durchgehendes oder reflektiertes Licht mehr gemessen werden kann. Ist der Brechungsindex in der Flüssigkeit dagegen merklich kleiner als in der Sonde, so kommt vornehmlich das unter dem zugehörigen Reflexionswinkel reflektierte Licht zur Meßseite, da es im Flüssigkeitsbereich keine merkliche Schwächung erfährt und somit als Meßgröße ungeeignet ist, um den Flüssigkeitspegel zuverlässig anzuzeigen. Die bekannte Sonde muß daher für Pegelmessungen in ihren Brechungseigenschaften sehr genau der zu messenden Flüssigkeit angepasst werden, was für viele Anwendungsfälle kaum möglich ist.

Der Erfindung liegt daher die Aufgabe zugrunde, einen optischen Sensor zu schaffen, der eine Vielzahl physikalischer Größen, die einen Einfluß auf den Brechungsindex oder die Lichtdurchlässigkeit eines Vergleichs- oder Meßmediums oder des Sensors selbst besitzen, auf optischem Wege erfaßt und als optische Signale abgibt. Zur Lösung dieser Aufgabe wird die in Anspruch 1 angegebene Merkmalskombination vorgeschlagen. Weitere vorteilhafte Ausgestaltungen, Weiterbildungen und Verwendungsmöglichkeiten der Erfindung ergeben sich aus den abhängigen Ansprüchen und den Verwendungsansprüchen.

Bei der erfindungsgemäßen Lösung wird einmal von dem physikalischen Prinzip Gebrauch gemacht, daß die in einem optischen Körper homogen verteilt angeordneten Lumineszenzteilchen ihre Anregungsenergie in Form von Licht abgeben, das in allen Richtungen gleichverteilt emittiert wird. Ist an eine lichtdurchlässige Begrenzungsfläche des erfindungsgemäßen Sondenkörpers ein Vergleichs- oder Meßmedium optisch angeschlossen, so wird das im Inneren des Sondenkörpers emittierte Lumineszenzlicht nach Maßgabe des Reflexionsgesetzes und des Brechungsgesetzes an der Begrenzungsfläche des Sondenkörpers zumindest teilweise reflektiert und tritt gegebenenfalls zum anderen Teil unter Richtungsänderung in das Vergleichs- oder Meßmedium aus. Tritt Licht von einem optisch dichteren in ein dünneres Medium, so wird es vom Einfallslot fortgebrochen. Überschreitet dabei der Einfallswinkel einen Grenzwinkel, bei welchem der gebrochene Strahl parallel zur Begrenzungsfläche des Sondenkörpers verläuft, so tritt Totalreflexion ein. Das von den Lumineszenzteilchen emittierte Licht wird in einem langgestreckten Sondenkörper nur dann zu den stirnseitigen Enden fortgeleitet, wenn sein Einfallswinkel an der lichtdurchlässigen Begrenzungsfläche größer als der Totalreflexionswinkel ist. Dabei wird jeweils die Hälfte des total-reflektierten Lumineszenzlichts zu einem der beiden stirnseitigen Enden geleitet. Der Rest des Lumineszenzlichts entweicht über die Begrenzungsfläche ins benachbarte Vergleichs- oder Meßmedium.

Die Intensität des in einem Querschnittsbereich, insbesondere in der Nähe der stirnseitigen Enden des Sondenkörpers auftretenden Lumineszenzlichts bildet eine einfach meßbare Größe, die je nach Anwendungsfall als Maß für verschiedene physikalische Meßgrößen verwendet werden kann. Insbesondere lassen sich auf diese Weise sprunghafte Veränderungen im Brechungsindex des Vergleichsmediums entlang der Begrenzungsfläche des Sondenkörpers feststellen. Besonders wirksam wird dieser Effekt, wenn an einer bestimmten Stelle längs des Sondenkörpers ein Übergang zwischen einem gegenüber dem Sondenmedium optisch dünneren zu einem optisch dichteren Vergleichsmedium eintritt. Im Bereich des optisch dichteren Vergleichsmediums wird annähernd das gesamte im Sondenkörper entstehende und dort ankommende Lumineszenzlicht aus dem Sondenkörper ausgekoppelt. Durch den Anschluß eines optisch dichteren Vergleichsmediums kann also eine Trennung der in verschiedenen Bereichen des Sondenkörpers entstehenden Lumineszenzstrahlung hervorgerufen und durch Intensitätsmessung meßtechnisch erfaßt und einer weiteren Signalverarbeitung zugeführt werden.

Gemäß einer bevorzugten Ausgestaltung der Erfindung wird in den erfindungsgemäßen Sensoren von der Fotolumineszenz, also von der Fluoreszenz oder Phosphoreszenz Gebrauch gemacht, die bei der Bestrahlung mit Licht oder Ultraviolettstrahlung auftritt. Bei der Wahl des Sondenmaterials ist es dabei grundsätzlich möglich, auf Materialien zurückzugreifen, die auch für Fluoreszenzkollektoren verwendet werden. Die Sensoren weisen bei den meisten Anwendungen eine langgestreckte zylindrische, plattenförmige oder folienförmige Gestalt auf, deren Querabmessung klein gegenüber ihrer Länge ist. Die Mantel- oder Breitseitenfläche des Sondenkörpers bildet dabei die lichtdurchlässige Begrenzungsfläche, an die das Vergleichs- oder Meßmedium optisch angeschlossen wird.

Die Primärlichtquelle sollte eine solche Lichtintensität besitzen, daß damit der überwiegende Teil der Fluoreszenz- oder Phosphoreszenzteilchen im Sondenkörper angeregt werden kann. Grundsätzlich ist auch ein gepulster Betrieb möglich, beispielsweise um Fremdlichtstörungen zu eliminieren. Auch hierbei sollte jedoch auf eine möglichst vollständige Aktivierung der vorhandenen Fluoreszenzteilchen geachtet werden. Die Lichtzufuhr zur Eintrittsstelle kann ebenso wie auch der Signaltransport von der Meßstelle mit Hilfe von Lichtleitfasern erfolgen. Die Umwandlung der optischen Signale in elektrische Signale kann mit einem beliebigen Fotoempfänger, beispielsweise einer Fotodiode, einem Fototransistor, einem Fotowiderstand oder einem Fotoelement erfolgen.

Zur Vermeidung einer Störung der Meßsignale durch das Primärlicht wird gemäß einer weiteren vorteilhaften Ausgestaltung der Erfindung vorgeschlagen, daß die Eintrittsstelle für das Primärlicht und die Meßstelle für das Fluoreszenzlicht am gleichen Ende des Sondenkörpers angeordnet sind und daß die stirnseitige Begrenzungsfläche am anderen Ende des Sondenkörpers lichtdurchlässig ist. Die Eintrittsstelle und die Meßstelle können dabei gemeinsam an einer stirnseitigen Begrenzungsfläche, beispielsweise seitlich nebeneinander oder koaxial zueinander angeordnet sein. Die Meßstelle kann auch durch ein an der Mantelfläche der Sonde angeordnetes Auskoppelprisma oder ein Auskoppelgitter gebildet sein.

Der erfindungsgemäße Sensor eröffnet eine Vielzahl von Anwendungsmöglichkeiten, die im folgenden kurz aufgezählt und in der nachfolgenden Spezialbeschreibung anhand der Zeichnung z. T. näher erläutert werden. Bei allen Anwendungen wird von einer räumlichen oder zeitlichen Variation des Brechungsindex in mindestens einem an den Sondenkörper angekoppelten Vergleichs- oder Meßmedium Gebrauch gemacht, die in einer Intensitätsvariation des an den Meßstellen aufgenommenen Lumineszenzlichts resultiert :

Füllstandsanzeige in Flüssigkeitsbehältern, Konzentrationsmessung in wässrigen und organischen Lösungen, Druck- und Temperaturmessung von Gasen, Konzentrationsmessung von Lösungen, Messung von Mischungsverhältnissen, Siedepunktüberwachung, z. B. bei sehr tiefen Temperaturen, Luftfeuchtebestimmungen, Regenmelder, Schalter, Tasten, Tastenfelder, Wasserwaagen und vieles andere mehr.

Im folgenden wird die Erfindung anhand einiger in der Zeichnung schematisch dargestellter Ausführungsbeispiele näher erläutert. Es zeigen :

Fig. 1 einen plattenförmigen optischen Sensor für die Füllstandsmessung in schaubildlicher Darstellung ;

Fig. 2 einen zylindrischen, optischen Sensor für die Füllstandsmessung ;

Fig. 3a bis e verschiedene Sensorvarianten mit unterschiedlich angeordneten Primärlichteintrittsstellen und Meßstellen ;

Fig. 4 eine Anordnung zur Lagemessung mit einem optischen Sensor ;

Fig. 5 eine Tastaturanordnung mit mehreren optischen Sensoren ;

Fig. 6 eine Tastaturanordnung mit einem optischen Sensor.

Die in der Zeichnung dargestellten Sensoren 10 bestehen aus einem optischen Körper 12 aus lichtdurchlässigem Material, in welchem Lumineszensteilchen 14 (Luminophore) über das Volumen möglichst homogen verteilt angeordnet sind. Die Lumineszenzteilchen werden durch Bestrahlung mit Licht, Ultraviolett-, Röntgen-, Gamma- oder Korpuskularstrahlen, durch chemische Vorgänge, durch Einwirkung elektrischer Felder oder durch elektrische Entladungsvorgänge in einen angeregten Zustand gebracht und kehren unter Emission von Licht, Infrarot- oder Ultraviolettstrahlung in ihren Grundzustand zurück. Bei den nachfolgend beschriebenen Sensoren wird ausschließlich von der Fotolumineszenz, also von der Fluoreszenz oder Phosphoreszenz Gebrauch gemacht, die bei der Bestrahlung mit Licht oder Ultraviolettstrahlung auftritt, obwohl auch die übrigen Lumineszenzarten prinzipiell anwendbar wären. Maßgeblich in diesem Zusammenhang ist allein die Tatsache, daß das Licht von der Gesamtheit der Lumineszenzteilchen in allen Richtungen gleich-verteilt emittiert wird.

Ist an eine lichtdurchlässige Begrenzungsfläche 16 des Sondenkörpers 12, dessen Brechungsindex $n_i$ ist, ein Vergleichs- oder Meßmedium L, W mit Brechungsindex $n_a$ optisch angeschlossen, so wird das Lumineszenzlicht nach Maßgabe des Reflexionsgesetzes und des Snelliusschen Brechungsgesetzes an der Begrenzungsfläche 16 des Sondenkörpers 12 zumindest teilweise reflektiert und tritt gegebenenfalls zum anderen Teil unter Richtungsänderung in das Vergleichs- oder Meßmedium L, W aus. Nach dem Brechungsgesetz gilt

$$n_i \times \sin\alpha_i = n_a \times \sin\alpha_a$$

wobei $\alpha_i$ und $\alpha_a$ den Einfallswinkel gegenüber dem Einfallslot im Sondenkörper (i) bzw. im Vergleichs- oder Meßmedium (a) bedeuten.

Tritt Licht von einem optisch dichteren in ein dünneres Medium ($n_a < n_i$), so wird es vom Einfallslot fortgebrochen. Totalreflexion tritt ein, wenn der Einfallswinkel $\alpha_i$ den Grenzwinkel $\alpha_t$ überschreitet, bei dem $\alpha_a = 90°$ wird, der also durch

$$\sin \alpha_t = n_a/n_i$$

definiert ist.

Das von den Lumineszenzteilchen emittierte Licht wird in einem langgestreckten Sondenkörper 12 nur dann zu den stirnseitigen Enden 18, 20 geleitet, wenn sein Einfallswinkel $\alpha_i$ an den lichtdurchlässigen Begrenzungsflächen 16 größer als der Totalreflexionswinkel $\alpha_t$ ist. Alles andere Lumineszenzlicht wird nach einer relativ kurzen Wegstrecke in der Größenordnung

$$a = d \times \tan \alpha_t$$

wobei d den Durchmesser bzw. die Wandstärke des Sondenkörpers 12 bedeutet, durch die Begrenzungsfläche hindurch in das Vergleichs- oder Meßmedium L, W aus. Eine Lichtleitung ergibt sich also nur dann, wenn das Vergleichs- oder Meßmedium optisch dünner als das Sondenmedium ist.

Da das Lumineszenzlicht in allen Richtungen gleich-verteilt emittiert und in einem geeigneten Sondenmaterial nur wenig absorbiert wird, ist es bei vorgegebener Geometrie eines Sondenkörpers und bei bekanntem Brechungsindex des Sondenmediums und des Vergleichs- oder Meßmediums aufgrund der vorstehenden physikalischen Gesetzmäßigkeiten möglich, den Anteil des innerhalb des Sondenkörpers entstehenden Lumineszenzlichts anzugeben, der zu den beiden stirnseitigen Enden 18, 20 des Sondenkörpers gelangt. Dieser Anteil beträgt bei einem langgestreckten zylindrischen Stab

$$\varepsilon_z = 1-\sin \alpha_t$$

und bei einem langgestreckten plattenförmigen Körper mit planparallelen Begrenzungsflächen 16 und verspiegelten Längsseitenkanten 22

$$\varepsilon_p = \cos\alpha_t$$

Je die Hälfte dieses Anteils wird zu einem der beiden stirnseitigen Enden 18, 20 geleitet. Der Rest des Lumineszenzlichts entweicht über die Begrenzungsfläche 16 ins benachbarte Vergleichs- oder Meßmedium L, W.

Die vorstehenden Formeln gelten nur für den Fall, daß das Sensormedium optisch dichter als das Vergleichs- oder Meßmedium ist. Andernfalls gilt in erster Näherung

$$\varepsilon = 0$$

d. h. daß kein Lumineszenzlicht zu den stirnseitigen Enden gelangt. Hierbei wurde das exakt in Längsrichtung des Sondenkörpers 12 abgestrahlte Lumineszenzlicht vernachlässigt, was um so besser erfüllt ist, je länger der Sondenkörper im Vergleich zu seinen Querabmessungen d ist.

Die Intensität des in einem Querschnittsbereich, insbesondere in der Nähe der stirnseitigen Enden 18, 20 des Sondenkörpers 12 auftretenden Lumineszenzlichts bildet eine einfach meßbare Größe, die je nach Anwendungsfall als Maß für verschiedene Einflußparameter verwendet werden kann. Diese Intensitätsmeßgröße kann vor allem durch eine Änderung des Verhältnisses der Brechungsindices $n_i$, $n_a$ zwischen Sensormedium einerseits und den angrenzenden Vergleichs- und/oder Meßmedien andererseits beeinflußt werden. Insbesondere lassen sich auf diese Weise sprunghafte Veränderungen im Brechungsindex $n_a$ des Vergleichsmediums entlang dem Sondenkörper 12 feststellen.

Besonders wirksam wird dieser Effekt, wenn an einer bestimmten Stelle längs des Sondenkörpers 12 ein Übergang 23 zwischen einem gegenüber dem Sondenmedium optisch dünneren zu einem optisch dichteren Vergleichsmedium eintritt. Im Bereich des optisch dichteren Vergleichsmediums W wird annähernd das gesamte im Sondenkörper 12 entstehende und dort ankommende Lumineszenzlicht aus dem Sondenkörper 12 ausgekoppelt. Durch den Anschluß eines optisch dichteren Vergleichsmediums kann also eine Trennung der in verschiedenen Bereichen des Sondenkörpers 12 entstehenden Lumineszenzstrahlung hervorgerufen und durch Intensitätsmessung meßtechnisch erfaßt und einer weiteren Auswertung zugeführt werden. Im folgenden wird dies anhand einiger praktischer Ausführungsbeispiele näher erläutert.

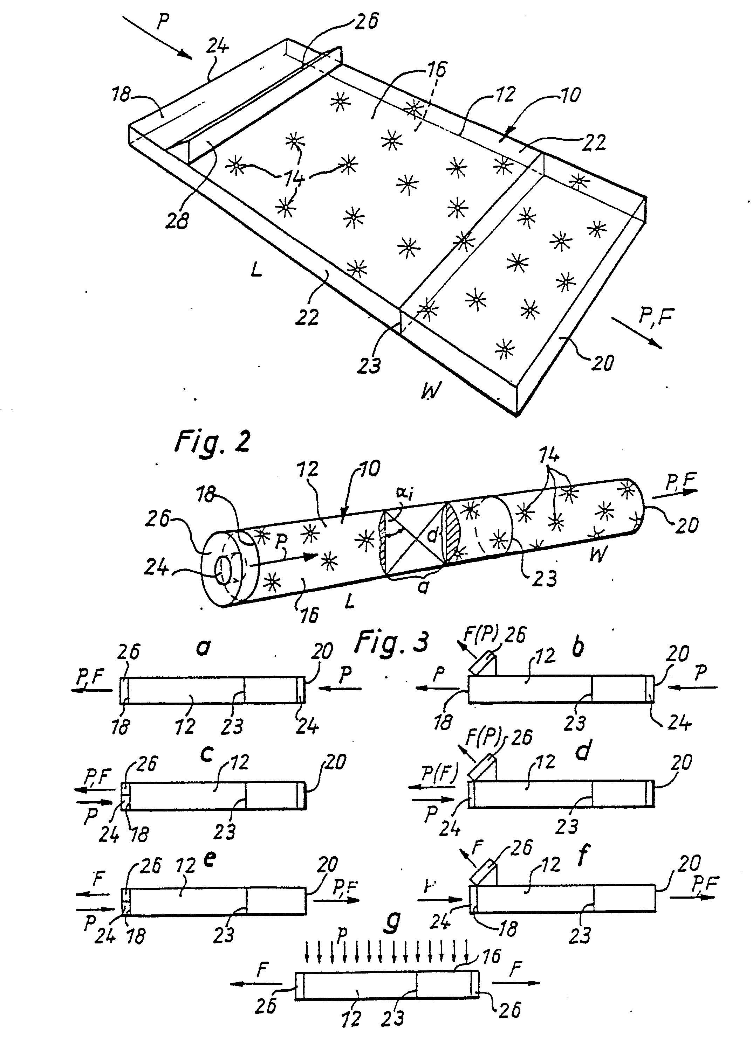

Bei den in Fig. 1 und 2 gezeigten Ausführungsbeispielen handelt es sich um optische Sensoren 10, die vor allem für die Füllstandsmessung in Flüssigkeitsbehältern einsetzbar sind. Die Sensoren 10 bestehen aus einer langgestreckten platten- bzw. folienförmigen (Fig. 1) oder zylindrischen (Fig. 2) Sonde aus lichtdurchlässigem Material, in welchem Fluoreszenzteilchen über das Volumen verteilt angeordnet sind. An einer Eintrittsstelle 24 wird beispielsweise mit Hilfe einer Lumineszenz- oder Laser-Diode Primärlicht P mit einer solchen Intensität und Wellenlänge zugeführt, daß der überwiegende Teil der in der Sonde enthaltenen Fluoreszenzteilchen 14 zur Lichtemission angeregt wird. Weiter enthält die Sonde eine Meßstelle 26, an der das zu dieser Stelle gelangende Fluoreszenzlicht F ausgekoppelt und einem Fotoempfänger zugeleitet wird. Als Fotoempfänger kommen beispielsweise Fotodioden, Fototransistoren, Fotowiderstände oder Fotoelemente in Betracht, die die ankommenden Signale in elektrische Signale umsetzen, so daß sie elektronisch zu Anzeige- und Steuerungszwecken weiterverarbeitet werden können.

Die Sonde wird mit ihrem einen Ende zweckmäßig bis zum Behälterboden in die Flüssigkeit W eingetaucht, so daß noch ein Teil der Sonde über den Flüssigkeitsspiegel 23 übersteht. Die Eintrittsstelle 24 für das Primärlicht P und die Meßstelle 26 für das Fluoreszenzlicht F befinden sich im Bereich des nicht in die Flüssigkeit eintauchenden Endes 18 der Sonde, also im optisch dünneren Vergleichsmedium, z. B. Luft L. Das andere Ende 20 der Sonde endet mit einer lichtdurchlässigen stirnseitigen Begrenzungsfläche am tiefsten Punkt des Behälters, so daß das an der Eintrittsstelle 24 eingespeiste Primärlicht P, welches nicht für Fluoreszenzprozesse verbraucht wird, ungestört austreten kann. Ebenfalls am unteren Ende 20 der Sonde tritt auch das in diese Richtung durch Totalreflexion geführte Fluoreszenzlicht aus. Das in die Gegenrichtung abgestrahlte und in der Sonde durch Totalreflexion geführte Fluoreszenzlicht wird am oberen Ende beispielsweise durch ein Prisma 28 oder ein Gitter aus dem Sondenkörper 12 ausgekoppelt und dem Fotoempfänger zugeführt. Mit einer solchen Anordnung wird erreicht, daß überschüssiges Primärlicht P auch hoher Intensität den Meßvorgang nicht stört, da es am unteren Sondenende 20 austritt und daher nicht zur Meßstelle gelangen kann.

An der Stelle des Flüssigkeitsspiegels 23 tritt ein Sprung im Brechungsindex $n_a$ des Vergleichsmediums auf. Je nach Höhe des Flüssigkeitsspiegels 23 gelangt bei gleichbleibender Intensität des Primärlichts P mehr oder weniger Fluoreszenzlicht zur Meßstelle 26. Die an der Meßstelle 26 gemessene Lichtintensität ist somit ein Maß für die Füllstandshöhe im Behälter.

Ist der Brechungsindex $n_i$ des Sondenkörpers 12 kleiner als der der Flüssigkeit W, so gelangt aus dem eintauchenden Bereich der Sonde praktisch kein Fluoreszenzlicht zur Meßstelle, da das dort entstehende Fluoreszenzlicht nahezu vollständig in die Flüssigkeit W entweicht.

In diesem Fall kommt Fluoreszenzlicht ausschließlich vom nicht eingetauchten Teil der Sonde zur Meßstelle 26, wenn angenommen wird, daß dort der Brechungsindex des Vergleichsmediums (Luft) kleiner als der der Sonde ist.

Grundsätzlich ist eine Messung jedoch auch dann möglich, wenn der Brechungsindex der Flüssigkeit W kleiner als der des Sondenmediums, aber größer als der der Luft L ist. In diesem Fall wird zwar ein Teil des im eingetauchten Bereich entstehenden Fluoreszenzlichts gleichfalls durch Totalreflexion zur Meßstelle 26 geleitet. Dieser Teil ist jedoch aufgrund des kleineren Totalreflexionswinkels kleiner als der entsprechende Teil aus dem nichteingetauchten Bereich, so daß auch hier eine Füllstandsänderung in einer Intensitätsänderung des gemessenen Fluoreszenzlichts resultiert.

Bei dem in Fig. 2 gezeigten Ausführungsbeispiel einer zylindrischen Sonde sind die Eintrittsstelle 24 für das Primärlicht P und die Meßstelle 26 für den Anschluß des Fotoempfängers koaxial zueinander an einem der stirnseitigen Sondenenden 18 angeordnet. Da das gegenüberliegende stirnseitige Sondenende 20 lichtdurchlässig ist, gelangt auch hier nur solches Fluoreszenzlicht zur Meßstelle 26, das entgegen der Strahlungsrichtung des Primärlichts P von den Fluoreszenzteilchen 14 emittiert und an der zylindrischen Begrenzungsfläche 16 totalreflektiert wird.

In den Figuren 3a bis g sind einige weitere Sondenvarianten mit unterschiedlicher Anordnung der Eintrittsstellen 24 und der Meßstellen 26 dargestellt.

Bei den Ausführungsbeispielen nach Fig. 3a und b wird das Primärlicht P an dem der Meßstelle 26 gegenüberliegenden Ende 20 im Bereich des dichteren Vergleichsmediums W zugeführt. Im Falle der Fig. 3a gelangt das Primärlicht P zusammen mit dem zu messenden Fluoreszenzlicht F unmittelbar zur Meßstelle, während im Falle der Fig. 3b zwar der größte Teil des Primärlichts P an der lichtdurchlässigen Stirnseitenfläche 18 austreten kann, aber noch zu einem kleineren Teil über das Prisma 28 an der Meßstelle 26 mit dem Fluoreszenzlicht F ausgekoppelt wird. Um eine Störung des Meßvorgangs durch das Primärlicht zu vermeiden, sind daher zusätzliche Vorkehrungen für eine Trennung dieser beiden Lichtanteile erforderlich, auf die hier nicht näher eingegangen werden soll.

Entsprechendes gilt auch für die in Fig. 3c und d gezeigten Ausführungsbeispiele, bei denen die Eintrittsstelle 24 für das Primärlicht P und die Meßstelle 26 zwar am gleichen Ende der Sonde angeordnet

6

sind, das andere Ende 20 aber verspiegelt ist und somit das überschüssige Primärlicht zumindest zum Teil zur Meßstelle zurückgelangen kann.

Eine wesentliche Verbesserung in dieser Hinsicht wird mit den in Fig. 3e, f und g gezeigten Ausführungsbeispielen erzielt, bei denen aufgrund der Lichtführung innerhalb der Sonde dafür Sorge getragen ist, daß das überschüssige Primärlicht nicht zur Meßstelle 26 gelangen kann. Bei dem Ausführungsbeispiel nach Fig. 3e befinden sich die Eintrittsstelle 24 und die Meßstelle 26 nebeneinander am einen stirnseitigen Ende 18 der Sonde, während das andere stirnseitige Ende 20 für den Durchtritt des Primärlichts und des dorthin gelangenden Anteils des Fluoreszenzlichts durchlässig ist. Auch bei der Anordnung nach Fig. 3f wird das Primärlicht an der einen Stirnseite 18 zugeführt und tritt an der anderen Stirnseite 20 zusammen mit dem dorthin gelangenden Fluoreszenzlicht aus, während das in entgegengesetzter Richtung emittierte Fluoreszenzlicht wiederum durch ein Prisma 28 ausgekoppelt wird.

Bei dem in Fig. 3g gezeigten Ausführungsbeispiel wird das Primärlicht P quer zur Längserstreckung der Sonde über deren Mantel- oder Breitseitenfläche 16 zugeführt und tritt auf der dieser gegenüberliegenden Breitseite wieder aus dem Sondenkörper aus. In diesem Fall können an beiden stirnseitigen Enden Meßstellen 26 für das Fluoreszenzlicht vorgesehen werden, zu denen kein Primärlicht gelangt.

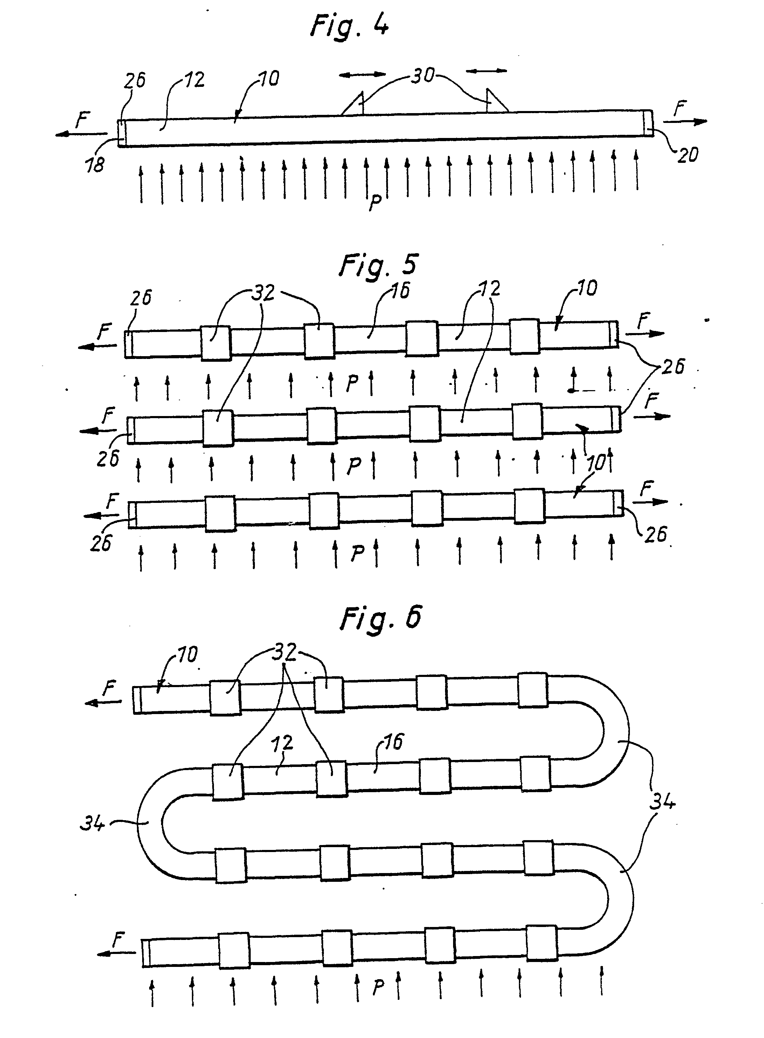

In Fig. 4 ist ein Ausführungsbeispiel einer Meßanordnung zur Lage- oder Längenmessung dargestellt. Auf einem langgestreckten optischen Sensor 10 der vorstehend beschriebenen Art ist mindestens ein Koppelprisma längsverschiebbar angeordnet. Die Basislänge des Koppelprismas sollte größenordnungsmäßig mindestens der Ansprechlänge $a = d \times \tan \alpha_t$ entsprechen, wobei $\alpha_t$ der Totalreflexionswinkel des Sondenkörpers 12 gegenüber der umgebenden Luft ist. Die Auskoppelung des Fluoreszenzlichts erfolgt über die Hypothenusenfläche der Prismen 30, so daß eine Richtungsabhängigkeit des ausgekoppelten Lichts erhalten wird. Die Einstrahlung des Primärlichts P kann entweder über eine der Stirnseiten 18, 20 oder, wie in Fig. 4 angedeutet, über die Mantel- bzw. Breitseitenfläche 16 des Sondenkörpers erfolgen. Die Meßstellen 26 für das Fluoreszenzlicht sind zweckmäßig an den stirnseitigen Enden 18, 20 des Sensorkörpers angeordnet. Die Intensität des an den Meßstellen 26 ankommenden Fluoreszenzlichts sowie deren Verhältnis oder Differenz bilden Maße für die Lage der Koppelprismen relativ zueinander und zu den Meßstellen.

Bei den in Fig. 5 und 6 gezeigten Tastaturanordnungen wird von dem vorstehend bereits erwähnten Prinzip Gebrauch gemacht, daß durch Anschließen eines optisch dichteren Auskopplers annähernd das gesamte in dem betreffenden Bereich entstehende und dort ankommende Fluoreszenzlicht aus dem Sondenkörper ausgekoppelt wird. Voraussetzung ist wiederum, daß die an die Begrenzungsfläche anliegende Basisfläche des Auskopplers sich mindestens über die Ansprechlänge $a = d \times \tan \alpha_t$ erstreckt, wobei $\alpha_t$ den Totalreflexionswinkel im Sondenkörper gegenüber dem benachbarten optisch dünneren Vergleichsmedium (Luft) und d die Dicke bzw. der Durchmesser des Sensorkörpers bedeuten.

Bei den in Fig. 5 und 6 gezeigten Ausführungsbeispielen sind die einzelnen im Abstand voneinander entlang den als langgestreckte Lichtleiter ausgebildeten Sondenkörpern 12 angeordneten Tasten 32 mit den genannten Auskopplern verbunden, die beim Anschlagen der Tasten 32 gegen die lichtdurchlässige Begrenzungsfläche 16 des Sondenkörpers 12 gedrückt werden. Dabei wird das zu den Meßstellen 26 an den stirnseitigen Enden 18, 20 gelangende Fluoreszenzlicht nach Maßgabe der augenblicklich gedrückten Taste in definierter Weise geschwächt. Aufgrund von Intensitätsmessungen an jeder der beiden Meßstellen 26 kann somit bestimmt werden, ob und gegebenenfalls welche Tasten 32 gedrückt sind. Weiter läßt sich durch Vergleich der Meßergebnisse beider Meßstellen oder durch Summenbildung überwachen, ob gleichzeitig zwei Tasten gedrückt sind. Eine zeitliche Überlappung des Andrucks zweier Tasten kann schaltungstechnisch eliminiert werden, da jeweils festgestellt werden kann, welche Taste zuerst und welche zuletzt angeschlagen wird.

Bei dem Ausführungsbeispiel nach Fig. 5 sind mehrere, mit getrennten Meßstellen 26 ausgestattete Sondenkörper 12 für jeweils eine Tastengruppe vorgesehen, während beim Ausführungsbeispiel nach Fig. 6 ein einziger langgestreckter Sondenkörper 12 mit mehreren lichtleitenden Abbiegungen 34 für das gesamte Tastenfeld vorhanden ist. Die Primärlichteinstrahlung P erfolgt jeweils über die Mantel- oder Breitseitenflächen 16 des Sondenkörpers 12, so daß zu den Meßstellen 26 kein Primärlicht gelangen kann.

**Patentansprüche**

1. Optischer Sensor für Meß-, Steuer- und Regelanordnungen mit einer durch Energiestrahlung zur Emission von Lumineszenzlicht anregbare Lumineszenzteilchen enthaltenden Sonde, die eine Meßstelle (26) zum Auskoppeln des dorthin gelangenden Lumineszenzlichts aufweist, gekennzeichnet durch einen langgestreckten, die Lumineszenzteilchen über sein Volumen verteilt enthaltenen Sondenkörper (12) aus einem lichtdurchlässigen, einen Brechungsindex $n_i$ aufweisenden Medium, der eine sich zumindest über einen Teil seiner Mantelfläche erstreckende lichtdurchlässige Begrenzungsfläche (16) aufweist, an der mindestens ein optisches Vergleichs- oder Meßmedium (L, W) mit Brechungsindex $n_a$ optisch anschließbar ist, wobei mindestens ein Vergleichs- oder Meßmedium (L) optisch dünner als das Sondenmedium ist und wobei sich die Meßstelle (26) in dem Bereich der lichtdurchlässigen Begrenzungsfläche (16) befindet, in welchem das optisch dünnere Vergleichs- oder Meßmedium (L) angeschlossen ist.

2. Sensor nach Anspruch 1, dadurch gekennzeichnet, daß mindestens zwei Vergleichs- oder Meßmedien (L, W) mit unterschiedlichen Brechungsindizes an die lichtdurchlässige Begrenzungsfläche (16) optisch anschließbar sind.

3. Sensor nach Anspruch 1 oder 2, dadurch gekennzeichnet, daß der Sondenkörper (12) als zylindrischer Körper, insbesondere als Lichtleitfaser, ausgebildet ist, dessen Mantelfläche die lichtdurchlässige Begrenzungsfläche (16) bildet oder enthält.

4. Sensor nach Anspruch 1 oder 2, dadurch gekennzeichnet, daß der Sondenkörper (12) als plattenförmiger oder folienförmiger Körper ausgebildet ist, dessen zumindest eine Breitseitenfläche die lichtdurchlässige Begrenzungsfläche (16) bildet oder enthält.

5. Sensor nach einem der Ansprüche 1 bis 4, dadurch gekennzeichnet, daß der Sondenkörper (12) zumindest im Bereich seiner lichtdurchlässigen Begrenzungsfläche (16) ebene oder schraubenförmige Windungen gegebenenfalls mit variabler Steigung aufweist.

6. Sensor nach einem der Ansprüche 1 bis 5, dadurch gekennzeichnet, daß die Lumineszenzteilchen als Fluoreszenz- oder Phosphoreszenzteilchen ausgebildet sind und daß die Sonde an mindestens einer Eintrittsstelle (24) mit Primärlicht (P) zur Anregung der Fluoreszenz- oder Phosphoreszenzteilchen beaufschlagbar ist.

7. Sensor nach Anspruch 6, dadurch gekennzeichnet, daß die Primärlichtquelle eine Lumineszenzdiode oder Laserdiode ist.

8. Sensor nach Anspruch 6 oder 7, dadurch gekennzeichnet, daß das Primärlicht intentitätsmoduliert ist.

9. Sensor nach einem der Ansprüche 1 bis 8, dadurch gekennzeichnet, daß das lichtdurchlässige Sondenmedium ein Festkörper, insbesondere aus Glas oder Kunststoff ist.

10. Sensor nach einem der Ansprüche 1 bis 8, dadurch gekennzeichnet, daß das lichtdurchlässige Sondenmedium eine in einem durchsichtigen, vorzugsweise zylindrischen Hüllrohr angeordnete Flüssigkeit ist.

11. Sensor nach einem der Ansprüche 1 bis 8, dadurch gekennzeichnet, daß das lichtdurchlässige Sondenmedium ein in einem durchsichtigen, vorzugsweise zylindrischen Hüllrohr angeordnetes Gas ist.

12. Sensor nach einem der Ansprüche 1 bis 11, dadurch gekennzeichnet, daß die Lumineszenzteilchen (14) im Sondenkörper (12) gleichverteilt angeordnet sind.

13. Sensor nach einem der Ansprüche 1 bis 12, dadurch gekennzeichnet, daß die Lumineszenzteilchen (14) eine über die Länge des Sondenkörpers (12) variable Verteilung aufweisen.

14. Sensor nach einem der Ansprüche 6 bis 13, dadurch gekennzeichnet, daß die Eintrittsstelle (24) für das Primärlicht (P) und die Meßstelle (26) für das Lumineszenzlicht am gleichen Ende (18) des Sondenkörpers (12) angeordnet sind, und daß die stirnseitige Begrenzungsfläche am anderen Ende (20) des Sondenkörpers (12) lichtdurchlässig ist.

15. Sensor nach Anspruch 14, dadurch gekennzeichnet, daß die Eintrittstelle (24) und die Meßstelle (26) gemeinsam an einer stirnseitigen Begrenzungsfläche (18) des Sondenkörpers (12) angeordnet sind.

16. Sensor nach Anspruch 14, dadurch gekennzeichnet, daß die Eintrittsstelle (24) an einem stirnseitigen Ende (18, 20) des Sondenkörpers (12) angeordnet ist und daß die Meßstelle (26) durch ein an der Mantel- oder Breitseitenfläche (16) des Sondenkörpers (12) angeordnetes Auskoppelprisma (28) oder Auskoppelgitter gebildet ist.

17. Sensor nach einem der Ansprüche 6 bis 16, dadurch gekennzeichnet, daß der Sondenkörper (12) eine sich zumindest über einen Teil seiner Länge erstreckende Eintrittsfläche für das vorzugsweise quer zur Längserstreckung des Sondenkörpers auftreffende Primärlicht (P) aufweist.

18. Sensor nach einem der Ansprüche 1 bis 17, dadurch gekennzeichnet, daß der Brechungsindex des Sondenkörpers durch äußere Einwirkung, wie Druck- oder Temperaturänderung oder Änderung der Konzentration eines gelösten Stoffes verstellbar ist.

19. Verwendung des Sensors nach einem der Ansprüche 1 bis 18 in einer Anordnung zur Messung, Steuerung und/oder Regelung des Füllstandes in einem Flüssigkeitsbehälter, dadurch gekennzeichnet, daß der Sondenkörper mit seiner lichtdurchlässigen Begrenzungsfläche (16) durch die Flüssigkeitsoberfläche (23) hindurch in die Flüssigkeit (W) so eingetaucht ist, daß ein Teil der Begrenzungsfläche (16) in den über der Flüssigkeitsoberfläche (23) befindlichen, ein gegenüber dem Sondenmedium optisch dünneres Medium (L) enthaltenden Raum übersteht, und daß an die im Bereich des überstehenden Teils der Begrenzungsfläche (16) angeordnete Meßstelle (26) ein auf die Intensität des Lumineszenzlicht ansprechender Fotoempfänger angeschlossen ist.

20. Verwendung nach Anspruch 19, dadurch gekennzeichnet, daß die Flüssigkeit (W) optisch dichter als das über ihrer Oberfläche (23) befindliche Medium (L) ist.

21. Verwendung nach Anspruch 19 oder 20, dadurch gekennzeichnet, daß die Flüssigkeit (W) optisch dichter als das Sondenmedium ist.

22. Verwendung des Sensors nach einem der Ansprüche 1 bis 18 in einer Anordnung zur Lage- oder Längenmessung, dadurch gekennzeichnet, daß der eine langgestreckte zylindrische oder plattenförmige Gestalt aufweisende Sondenkörper (12) in einem optisch dünneren Vergleichsmedium (L) angeordnet ist, daß mindestens ein Lagemeßkörper aus einem optisch dichteren Material entlang der sich über die Länge des Sondenkörpers erstreckenden lichtdurchlässigen Begrenzungsfläche verschiebbar angeordnet und an diese gegebenenfalls unter Zwischenschalten einer Flüssigkeit optisch ankoppelbar ist, und daß an

8

mindestens eine im Bereich der Enden des Sondenkörpers angeordnete Meßstelle ein auf die Intensität des Lumineszenzlichts ansprechender Fotoempfänger angeschlossen ist.

23. Verwendung nach Anspruch 22, dadurch gekennzeichnet, daß der Lagemeßkörper als rechtwinkliges Prisma ausgebildet ist, das mit seiner einen Kathetenfläche gegen die lichtdurchlässige Begrenzungsfläche (16) des Sondenkörpers (12) anliegt.

24. Verwendung nach Anspruch 23, dadurch gekennzeichnet, daß die gegen die Begrenzungsfläche (16) des Sondenkörpers (12) anliegende Kathetenfläche des Prismas in Längserstreckung des Sondenkörpers (12) mindestens der Ansprechlänge $a = d \times \tan\alpha_t$ des Sondenkörpers entspricht, wobei d den Durchmesser oder die Wandstärke des Sondenkörpers und $\alpha_t$ den Totalreflexionswinkel des Sondenkörpers gegenüber Luft bedeuten.

25. Verwendung des Sensors nach einem der Ansprüche 1 bis 18 in einer Anordnung zur Messung des Brechungsindexes in einer Flüssigkeit oder einem Gas, insbesondere in Anwendung zur Bestimmung der Konzentration einer wässrigen oder organischen Lösung oder des Gasdrucks, dadurch gekennzeichnet, daß der Sondenkörper zumindest teilweise in die Flüssigkeit oder das Gas eintaucht und einen an den Brechungsindex der Flüssigkeit oder des Gases angleichbaren variablen Brechungsindex aufweist.

26. Verwendung nach Anspruch 25, dadurch gekennzeichnet, daß das Sondenmedium aus einer Flüssigkeitslösung mit einstellbarer Konzentration des gelösten Stoffes besteht.

27. Verwendung nach Anspruch 25, dadurch gekennzeichnet, daß das Sondenmedium aus einem Gas mit einstellbarem Druck besteht.

28. Verwendung nach Anspruch 25, dadurch gekennzeichnet, daß der Brechungsindex der aus einem Festkörper bestehenden Sonde durch Druckbeaufschlagung verstellbar ist.

29. Verwendung nach Anspruch 25, dadurch gekennzeichnet, daß der Sondenkörper einen über seine Länge zur Meßstelle hin monoton ansteigenden Brechungsindex aufweist, der zumindest an einer Stelle dem Brechungsindex des Vergleichs- oder Meßmediums entspricht.

30. Verwendung mindestens eines der Sensoren nach einem der Ansprüche 1 bis 15 in einer Tastaturanordnung, dadurch gekennzeichnet, daß die im Abstand voneinander längs des langgestreckten Sondenkörpers (12) angeordneten Tasten (32) einen gegen die lichtdurchlässige Begrenzungsfläche andrückbaren Koppelkörper aus optisch dichterem Material als das Sondenmedium aufweisen, und daß im Bereich der stirnseitigen Enden des Sondenkörpers mindestens eine Meßstelle für den Anschluß eines Fotoempfängers angeordnet ist.

## Claims

1. Optical sensor for measurement, control and regulating systems, having a probe containing luminescent particles which can be excited by energy radiation to emit luminescent light, said probe exhibiting a measurement point (26) for coupling out the luminescent light that reaches it, characterised by an elongate probe body (12) which contains the luminescent particles distributed throughout its volume and is made from a light-transmitting medium having a refractive index $n_i$, said probe having a boundary surface (16) extending at least along part of its envelope surface and which transmits light, at which boundary surface (16) at least one optical comparison or measurement medium (L, W) with a refractive index $n_a$ can be optically connected, at least one comparison or measurement medium (L) being optically thinner than the probe medium, and the measurement point (26) being situated in the region of the light-transmitting boundary surface (16) in which the optically thinner comparison or measurement medium (L) is connected.

2. Sensor according to Claim 1, characterised in that at least two comparison or measurement media (L, W) having different refractive indices can be optically connected to the light-transmitting boundary surface (16).

3. Sensor according to Claim 1 or 2, characterised in that the probe body (12) is constructed as a cylindrical body, in particular as an optical fibre, the envelope surface of which constitutes or contains the light-transmitting boundary surface (16).

4. Sensor according to Claim 1 or 2, characterised in that the probe body (12) is constructed as a plate-like or sheet-like body, the at least one broad wall surface of which constitutes or contains the light-transmitting boundary surface (16).

5. Sensor according to any of Claims 1 to 4, characterised in that at least in the region of its light-transmitting boundary surface (16), the probe body (12) exhibits plane or helical windings, with variable pitch if required.

6. Sensor according to any of Claims 1 to 5, characterised in that the luminescent particles are in the form of fluorescent or phosphorescent particles and that the probe can be exposed at at least one entry point (24) to primary light (P) to excite the fluorescent or phosphorescent particles.

7. Sensor according to Claim 6, characterised in that the primary light source is a luminescence diode or laser diode.

8. Sensor according to Claim 6 or 7, characterised in that the primary light is intensity modulated.

9. Sensor according to any of Claims 1 to 8, characterised in that the light-transmitting probe medium is a solid body, especially one made from glass or plastic.

9

10. Sensor according to any of Claims 1 to 8, characterised in that the light-transmitting probe medium is a liquid disposed in a transparent, preferably cylindrical shell.

11. Sensor according to any of Claims 1 to 8, characterised in that the light-transmitting probe medium is a gas disposed in a transparent, preferably cylindrical shell.

12. Sensor according to any of Claims 1 to 11, characterised in that the luminescence particles (14) are uniformly distributed in the probe body (12).

13. Sensor according to any of Claims 1 to 12, characterised in that the luminescence particles (14) exhibit variable distribution along the length of the probe body (12).

14. Sensor according to any of Claims 6 to 13, characterised in that the entry point (24) for the primary light (P) and the measurement point (26) for the luminescent light are arranged at the same end (18) of the probe body (12), and that the outside boundary surface at the other end (20) of the probe body (12) transmits light.

15. Sensor according to Claim 14, characterised in that the entry point (24) and the measurement point (26) are arranged in common on one outside boundary surface (18) of the probe body (12).

16. Sensor according to Claim 14, characterised in that the entry point (24) is arranged on one outside end (18, 20) of the probe body (12) and that the measurement point (26) is constituted by an output prism (28) or output lattice arranged on the envelope surface or broad wall surface (16) of the probe body (12).

17. Sensor according to any of Claims 6 to 16, characterised in that the probe body (12) exhibits an entry surface extending at least along part of its length for the primary light (P) that is preferably incident at right angles to the longitudinal span of the probe body.

18. Sensor according to any of Claims 1 to 17, characterised in that the refractive index of the probe body can be adjusted by external action, such as a change in pressure or temperature or a change in the concentration of a dissolved substance.

19. Use of the sensor according to any of Claims 1 to 18 in a system for measuring, controlling and/or regulating the level of liquid in a tank, characterised in that the probe body with its light-transmitting boundary surface (16) is so immersed through the surface of the liquid (23) into the liquid (W) that part of the boundary surface (16) projects into the area above the surface of the liquid (23) which contains a medium (L) optically thinner than the probe medium, and that a photoreceiver which reacts to the intensity of the luminescent light is connected to the measurement point (26) arranged in the region of the projecting part of the boundary surface (16).

20. Use according to Claim 19, characterised in that the liquid (W) is optically denser than the medium (L) located above its surface (23).

21. Use according to Claim 19 or 20, characterised in that the liquid (W) is optically denser than the probe medium.

22. Use of the sensor according to any of Claims 1 to 18 in a system for localisation or linear measurement, characterised in that the probe body (12), which has an elongate or plate-like shape, is arranged in an optically thinner comparison medium (L), that at least one position measuring body made from an optically denser material is displaceably arranged along the light-transmitting boundary surface that extends over the length of the probe body and if necessary can be optically coupled to said boundary surface by interposing a liquid, and that to at least one measurement point arranged in the region of the ends of the probe body there is connected a photoreceiver which reacts to the intensity of the luminescent light.

23. Use according to Claim 22, characterised in that the position measuring body is constructed as a rectangular prism which with one perpendicular side face abuts the light-transmitting boundary surface (16) of the probe body (12).

24. Use according to Claim 23, characterised in that the perpendicular side face of the prism abutting the boundary surface (16) of the probe body (12) corresponds to at least the reaction length $a = d \times \tan \alpha_t$ of the probe body (12) in the longitudinal span of the probe body, where d denotes the diameter or wall thickness of the probe body and $\alpha_t$ the total reflection angle of the probe body with respect to air.

25. Use of the sensor according to any of Claims 1 to 18 in a system for measuring the refractive index in a liquid or gas, especially when used to determine the concentration of an aqueous or organic solution, or gas pressure, characterised in that the probe body is at least partially immersed in the liquid or the gas and exhibits a variable refractive index which can be adjusted to the refractive index of the liquid or gas.

26. Use according to Claim 25, characterised in that the probe medium consists of a liquid solution having an adjustable concentration of the dissolved substance.

27. Use according to Claim 25, characterised in that the probe medium consists of a gas having adjustable pressure.

28. Use according to Claim 25, characterised in that the refractive index of the probe consisting of a solid body can be adjusted by subjecting it to pressure.

29. Use according to Claim 25, characterised in that the probe body has a refractive index that rises monotonously over its length to the measurement point, said refractive index corresponding at least at one point to the refractive index of the comparison or measurement medium.

30. Use of at least one of the sensors according to any of Claims 1 to 15 in a keyboard arrangement, characterised in that the keys (32) spaced along the elongate probe body (12) exhibit a coupling body made from optically denser material than the probe medium which can be pressed against the light-transmitting boundary surface, and that in the region of the outside ends of the probe body there is arranged at least one measurement point for the connection of a photoreceiver.

## Revendications

1. Capteur optique pour des systèmes de mesure, de commande et de réglage, avec une sonde contenant des particules luminescentes pouvant être excitées, par un rayonnement énergétique, à l'émission de lumière de luminescence et comprenant un point de mesure (26) pour le découplage de la lumière de luminescence parvenant audit point de mesure, caractérisé en ce qu'il comprend un corps de sonde (12) de forme allongée réalisé à partir d'un matériau transparent d'un indice de réfraction $n_i$ et contenant les particules luminescentes réparties sur tout son volume, lequel corps de sonde présente une surface périphérique (16) transparente qui s'étend sur au moins une partie de son enveloppe et à laquelle peut être rattaché optiquement au moins un milieu de comparaison ou de mesure (L, W) avec un indice de réfraction $n_a$, au moins l'un des milieux de comparaison ou de mesure (L) étant optiquement moins dense que le milieu de la sonde et le point de mesure (26) étant situé dans la région de la surface périphérique transparente (16) dans laquelle est rattaché le milieu de comparaison ou de mesure (L) optiquement moins dense.

2. Capteur selon la revendication 1, caractérisé en ce qu'au moins deux milieux de comparaison ou de mesure (L, W) avec des indices de réfraction différents peuvent être couplés optiquement avec la surface périphérique transparente (16).

3. Capteur selon l'une des revendications 1 ou 2, caractérisé en ce que le corps de sonde (12) est conformé en corps cylindrique, en particulier en fibre optique, dont l'enveloppe constitue ou contient la surface périphérique transparente (16).

4. Capteur selon l'une des revendications 1 ou 2, caractérisé en ce que le corps de sonde (12) est conformé en plaque ou en feuille dont au moins une face de grand côté constitue ou contient la surface périphérique transparente (16).

5. Capteur selon l'une quelconque des revendications 1 à 4, caractérisé en ce que le corps de sonde (12) présente, du moins dans la région de sa surface périphérique transparente (16), des spires planes ou hélicoïdales, éventuellement avec un pas d'hélice variable.

6. Capteur selon l'une quelconque des revendications 1 à 5, caractérisé en ce que les particules luminescentes sont constituées par des particules fluorescentes ou phosphorescentes et que la sonde permet l'injection de la lumière primaire (P) à au moins un point d'entrée (24) pour l'excitation des particules fluorescentes ou phosphorescentes.

7. Capteur selon la revendication 6, caractérisé en ce que la source de lumière primaire est une diode électroluminescente ou une diode laser.

8. Capteur selon l'une des revendications 6 ou 7, caractérisé en ce que la lumière primaire est modulée en intensité.

9. Capteur selon l'une quelconque des revendications 1 à 8, caractérisé en ce que le milieu de sonde transparent est un corps solide, en particulier en verre ou en matière plastique.

10. Capteur selon l'une quelconque des revendications 1 à 8, caractérisé en ce que le milieu de sonde transparent est un liquide placé dans une gaine transparente, de préférence cylindrique.

11. Capteur selon l'une quelconque des revendications 1 à 8, caractérisé en ce que le milieu de sonde transparent est un gaz placé dans une gaine transparente, de préférence cylindrique.

12. Capteur selon l'une quelconque des revendications 1 à 11, caractérisé en ce que les particules luminescentes (14) sont réparties uniformément dans le corps de sonde (12).

13. Capteur selon l'une quelconque des revendications 1 à 12, caractérisé en ce que les particules luminescentes (14) présentent une distribution variable sur la longueur du corps de sonde (12).

14. Capteur selon l'une quelconque des revendications 6 à 13, caractérisé en ce que le point d'entrée (24) pour la lumière primaire (P) et le point de mesure (26) pour la lumière de luminescence se situent à la même extrémité (18) du corps de sonde (12), et que la surface périphérique frontale à l'autre extrémité (20) du corps de sonde (12) est transparente.

15. Capteur selon la revendication 14, caractérisé en ce que le point d'entrée (24) et le point de mesure (26) sont disposés ensemble sur l'une des extrémités périphériques frontales (18) du corps de sonde (12).

16. Capteur selon la revendication 14, caractérisé en ce que le point d'entrée (24) se situe à l'une des extrémités frontales (18, 20) du corps de sonde (12) et que le point de mesure (26) est constitué par un prisme de découplage (28) ou un réseau de découplage disposé sur l'enveloppe ou sur la face de grand côté (16) du corps de sonde (12).

17. Capteur selon l'une quelconque des revendications 6 à 16, caractérisé en ce que le corps de sonde (12) présente une face d'entrée pour la lumière primaire (P) arrivant, de préférence, transversalement à l'extension longitudinale du corps de sonde, qui s'étend au moins sur une partie de la longueur dudit corps de sonde.

18. Capteur selon l'une quelconque des revendications 1 à 17, caractérisé en ce que l'indice de réfraction du corps de sonde peut être modifié par une action extérieure telle que la variation de la pression ou de la température ou la variation de la concentration d'une substance en solution.

19. Utilisation d'un capteur selon l'une quelconque des revendications 1 à 18 dans un système pour la mesure, la commande et/ou le réglage du niveau de remplissage d'un réservoir de liquide, caractérisée en ce que le corps de sonde est plongé avec sa surface périphérique transparente (16), à travers le niveau de liquide (23), dans le liquide (W) de telle façon qu'une partie de la surface périphérique transparente (16) dépasse dans l'espace situé au-dessus du niveau du liquide (23) et contenant un milieu (L) optiquement moins dense que le milieu de la sonde, et qu'un photodétecteur répondant à l'intensité de la lumière de luminescence est relié au point de mesure (26) placé dans la région de la partie en saillie de la surface périphérique transparente (16).

20. Utilisation selon la revendication 19, caractérisée en ce que le liquide (W) est optiquement plus dense que le milieu (L) situé au-dessus de sa surface (23).

21. Utilisation selon l'une des revendications 19 ou 20, caractérisée en ce que le liquide (W) est optiquement plus dense que le milieu de la sonde.

22. Utilisation d'un capteur selon l'une quelconque des revendications 1 à 18 dans un système pour la mesure de positions ou de longueurs, caractérisée en ce que le corps de sonde (12) présentant une forme allongée de cylindre ou de plaque est placé dans un milieu de comparaison (L) optiquement moins dense, qu'au moins un élément de mesure de position réalisé en un matériau optiquement plus dense est disposé de façon à pouvoir être déplacé le long de la surface périphérique transparente qui s'étend sur la longueur du corps de sonde et qu'il peut être couplé optiquement, éventuellement avec interposition d'un liquide, avec ladite surface périphérique ; et qu'un photodétecteur répondant à l'intensité de la lumière de luminescence est relié à au moins un point de mesure placé dans la région des extrémités du corps de sonde.

23. Utilisation selon la revendication 22, caractérisée en ce que l'élément de mesure de position est conformé en prisme rectangle qui est appliqué avec l'un des côtés de l'angle droit contre la surface périphérique transparente (16) du corps de sonde (12).

24. Utilisation selon la revendication 23, caractérisée en ce que la face de l'un des côtés de l'angle droit du prisme appliquée contre la surface périphérique transparente (16) du corps de sonde (12) correspond au moins, dans l'extension longitudinale du corps de sonde (12), à la longueur de sensibilité $a = d \times \tan \alpha_t$ du corps de sonde, d désignant le diamètre ou l'épaisseur de paroi du corps de sonde et $\alpha_t$ l'angle de réflexion totale du corps de sonde par rapport à l'air.

25. Utilisation du capteur selon l'une quelconque des revendications 1 à 18 dans un système pour la mesure de l'indice de réfraction dans un liquide ou dans un gaz, en particulier pour la détermination de la concentration d'une solution aqueuse ou organique ou de la pression de gaz, caractérisée en ce que le corps de sonde est plongé du moins partiellement dans le liquide ou le gaz et qu'il présente un indice de réfraction variable pouvant être adapté à l'indice de réfraction du liquide ou du gaz.

26. Utilisation selon la revendication 25, caractérisée en ce que le milieu de sonde est constitué par une solution de liquide avec une concentration réglable de la substance en solution.

27. Utilisation selon la revendication 25, caractérisée en ce que le milieu de sonde est constitué par un gaz dont la pression est réglable.

28. Utilisation selon la revendication 25, caractérisé en ce que l'indice de réfraction de la sonde réalisée à partir d'une matière solide peut être varié par mise sous pression.

29. Utilisation selon la revendication 25, caractérisée en ce que le corps de sonde présente un indice de réfraction qui croît de manière monotone sur sa longueur en direction du point de mesure et qui correspond, à au moins un endroit, à l'indice de réfraction du milieu de comparaison ou de mesure.

30. Utilisation d'au moins l'un des capteurs selon l'une quelconque des revendications 1 à 15 dans un agencement de clavier, caractérisée en ce que les touches (32) disposées à distance les unes des autres le long du corps de sonde (12) allongé présentent un corps de couplage applicable contre la surface périphérique transparente et réalisé en un matériau optiquement plus dense que le milieu de la sonde, et qu'au moins un point de mesure pour le raccordement d'un photodétecteur est prévu dans la région des extrémités frontales du corps de sonde.

Fig. 2

Fig. 3

## Fig. 4

## Fig. 5

## Fig. 6